# EUROPEAN PATENT APPLICATION

(11) **EP 4 560 701 A1**
(43) Date of publication of application: **28.05.2025**
(21) Application number: 23212158.2
(22) Date of filing: 26.11.2023
(51) Int. Cl.: H01L 23/488, H01L 23/498, H01L 23/00, H01L 25/07

(54) **POWER MODULE FOR HIGH CURRENT APPLICATIONS**

(71) Applicant: Bayerische Motoren Werke Aktiengesellschaft, 80809 München (DE)
(72) Inventor: VILLARRUEL-PARRA, Alejandro, 3919 Porsgrunn (NO); JI, Chao, Nottingham NG9 2AS (GB); BURTON, Christian, Caerphilly CF83 1EJ (GB); BOCK, David, 85669 Pastetten (DE)
(74) Representative: HGF

(57) **Abstract**

The invention relates to a power module for high current applications having two plate-shaped busbars, each with an outer contact tongue for electrically connecting the power module to a respective power supply line and with several inner contact tongues for connecting to a respective conductor track, which are leading to a contact point of a semiconductor chip. The bus bars are arranged in close proximity, and the current flow in the bus bars is oriented in an anti-parallel manner to avoid parasitic induction.

The power module is characterized by the fact that a terminal pin for a four-point measurement is provided on each bus bar.

## Description

The present invention relates to a power module for high current applications, in particular a power module suitable for switching high currents in a motor vehicle, such as occur in electrically driven motor vehicles.

WO 2018/007062 A1 describes a power module with two electrically insulated layers arranged one above the other to conduct anti-parallel currents. This is intended to avoid parasitic inductions and to provide a more reliable power supply with high current.

On the website https://resources.altium.com/DE/P/parasitaere-lnduktivitaeten-und-Leistungshalbleiter-eine-unglueckliche-Paarung, under the title "parasitaere Induktivitaeten und Leistungshalbleiter eine unglueckliche Paarung" (English: "Parasitic inductors and power semiconductors - an unfortunate pairing"), by Florian Störmer, generated on August 27, 2019 and updated on October 14, 2020, it is explained how in PCB design parasitic inductors lead to EMI problems. This is a significant problem especially in the context of power semiconductors, such as MOSFETs or IGBTs and SiC MOSFETs in particular, and often negates the advantage of high switching frequencies and the associated loss reduction. In principle, the areas circumscribed by current paths should be kept as small as possible. The placement of decoupling capacitors can mitigate effects where optimal design is impractical.

The invention is based on the object of creating a power module for high current applications which allows reliable monitoring of the potentials for both direct current and alternating current.

The object is solved by a power module having the features of claim 1. Advantageous embodiments of the invention are indicated in the respective subclaims.

A power module for high current applications according to the invention has two plate-shaped busbars, each with an outer contact tongue for electrically connecting the power module to a respective power supply line and with several inner contact tongues for connecting to a respective conductor track, leading to a contact point of a semiconductor chip or a plurality of semiconductor chips. The bus bars are arranged in close proximity, and the current flow in the bus bars is oriented in an anti-parallel manner to avoid parasitic induction.

The power module is characterized by the fact that a terminal pin for a four-point measurement is provided on each bus bar.

The busbars can be arranged in an intimate antiparallel fashion.

The fact that the busbars each have a terminal pin means that a four-point measurement, also known as a Kelvin measurement, can be carried out, whereby the current supplied to the power module can be measured from outside in the line connected to the external contact tongues and the voltage dropped in the power module can be measured at the terminal pins. In conventional power modules, a four-point measurement is also possible in principle, but here the voltage is tapped in the lines connected to the external contact tongues. When tapping the voltage at the lines connected to the external contact tongues, however, there is the disadvantage that the signal is superimposed by noise generated by the switching of the current. Particularly when switching high currents, oscillations occurs, which can additionally be altered or increased by parasitic induction in the current-carrying leads. By arranging the terminal pins directly at the busbars, on the one hand the switching noise interference is low, since the terminal pins are arranged very close to the semiconductor chips switching the current, and on the other hand the influence of parasitic induction is low, since the busbars themselves conduct the current in an antiparallel manner and are arranged closely adjacent to each other, so that no or only a low parasitic induction occurs in the area of the busbars. As a result, the voltage can be sampled very reliably via the terminal pins and thus a very precise four-point measurement can be carried out, with the current in the lines connected to the outer contact tongues and the voltage being detected via the terminal pins.

The design of the power module is die-agnostic and can be accommodate power semiconductors from different suppliers. This ensures compatibility and interchangeability with different brands and types of power semiconductors, thereby providing unparalleled flexibility and freedom in the selection of components. The agnostic design not only facilitates the integration of power semiconductors from different manufacturers but also future-proofs the device by allowing it to adapt to upcoming technologies and market changes effortlessly. By doing so, it guarantees a sustainable and long-term operation of the device, minimizing the risk of obsolescence and dependency on specific suppliers, while simultaneously enhancing its adaptability and relevance in the ever-evolving electronic landscape.

Preferably, the terminal pins are arranged on the same side of the power module and protrude a bit. This means that the voltage can easily be tapped permanently or temporarily at the terminal pins.

The terminal pins can be arranged at the edge area of the busbars adjacent to the side of the busbars where the inner contact tongues are located. This keeps the distance to the inner contact tongues small, which significantly counteracts falsification of the voltage signal.

Preferably an insulation layer is provided in between the two busbars.

The busbars can have at least four internal contact tongues, preferably at least eight internal contact tongues and in particular at least twelve internal contact tongues.

The distance between the busbars is preferably no greater than 0.5 mm, in particular no greater than 1 mm and especially no greater than 3 mm. The smaller the distance between busbars is, the lower is the parasitic inductance. The distance is measured between the opposing surfaces of the two busbars.

The plate-shaped busbars are formed from a material with good electrical conductivity, such as a copper alloy or aluminium alloy.

Moreover, typically a plating may be applied to extend usable lifespan, enhance skin depth effects or to add bonding during jointing processes such as soldering, conductive gluing or sintering.

The busbars are configured to be connected by means of the outer contact tongue with a push-on connector, or by permanent connection methods to include, but not limited to: soldering, sintering, laser welding, general welding techniques and diffusion bonding via surface modification as is practiced within the industry currently.

The busbars can have a thickness of at least 0.2 mm, in particular at least 0.5 mm, 1 to 3 mm scale also being possible. They may also be of multiple thicknesses a commonly practiced within copper strip modification.

The outer contact tongue and the inner contact tongues of a busbar are arranged on diametrically opposite sides of the busbar in each case.

Preferably, the side of the busbar on which the at least one inner contact tongue is arranged is longer than the side of the busbar on which the outer contact tongue is arranged.

The outer contact tongue is preferably wider than one or more inner contact tongue. Since several inner contact tongues are usually provided, the current of the one outer contact tongue is distributed over the several inner contact tongues.

Preferably, the connections of the conductor tracks with the contact tongues and/or contact points of one of the semiconductor chips are electrically and mechanically connected by means of a sintered connection structure. Such a sintered connection structure has the advantage over a soldered connection that it can be reheated after its formation without the connection structure coming loose. This means that several sintered connection structures can be formed successively on the power module without a previously applied sintered connection structure becoming detached again as a result of the heating of a sintered connection structure applied later. Moreover, an increase in joint lifespan and robustness may be achieved by the use of sinter-based processes.

Two conductor tracks may be placed in close proximity with an insulating layer between them, and the current flow in the conductor tracks may be oriented in an antiparallel manner to avoid parasitic induction.

One of the two conductor tracks may be disposed substantially between the other conductor track and the surface of a carrier board on which the semiconductor chip is located.

Preferably, each electrical connection between a contact point of the semiconductor chip and an inner contact tongue or a further contact point of the same or a further semiconductor chip is formed by means of a conductor track, the conductor track preferably being a plate-shaped, electrically conductive body. The conductor track can be formed from a metal with good electrical conductivity, in particular a copper alloy or aluminium alloy.

The electrical connection between the inner contact tongues and the corresponding conductor tracks is preferably embodied by means of an electrically conducting substrate to which both the contact tongues and the conductor tracks are electrically connected.

The semiconductor chips consist preferably of high-power semiconductor variants such as a high-power field-effect transistor (MOSFET, JFET, HEMT, etc) or a high-power insulated-gate bipolar transistor (IGBT) either with or without high-power diodes connected in anti-parallel configuration.

The power units can incorporate a connection to an integrated component to mitigate the electromagnetic interference (EMI) generated by the power transistor operation.

This inclusion of an integrated component, which can also be a semiconductor chip, is helping to damp the EMI produced, ensuring that the system operates efficiently without succumbing to the disruptive effects of electromagnetic noise.

An advantage is that it is reducing the overall size and weight of the system. The integration of compact components to handle EMI, the design eliminates the need for bulky external devices or additional shielding mechanisms traditionally used for EMI suppression. This leads to a streamlined and lightweight system, without compromising on the system's reliability and electromagnetic compatibility.

An example of an embodiment of the invention is shown in the drawings. The drawings schematically show in:
- Figure 1: an embodiment of a power module in perspective view, which is not part of the invention and serves only for general technical explanation,
- Figure 2: a side view of the power module from Figure 1,
- Figure 3: a perspective view of an embodiment of two power units of a power module in the area of the carrier board, which corresponds to the embodiment in Figures 1 and 2,
- Figure 4: a side view of one of the power units from Figure 3, and

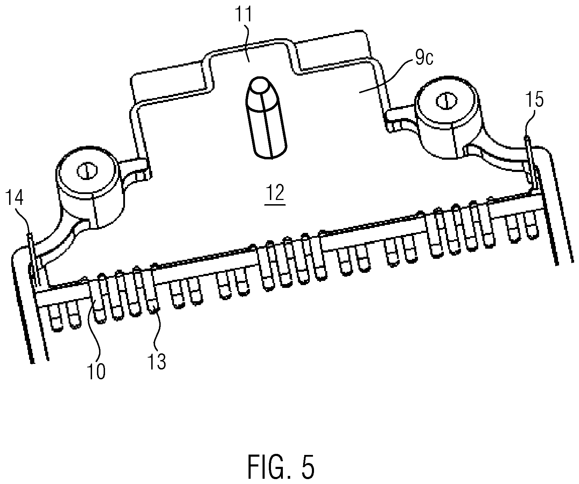

- Figure 5: a section of a power module in the area of busbars, which is designed according to the invention and otherwise corresponds to the embodiment from Figures 1 to 4, and
- Figure 6: an equivalent circuit diagram of a power unit of the power module from Figures 3 to 5.

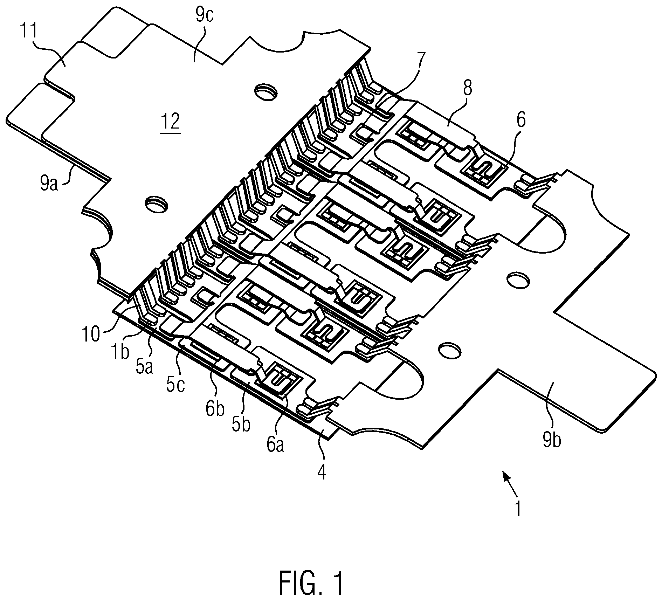

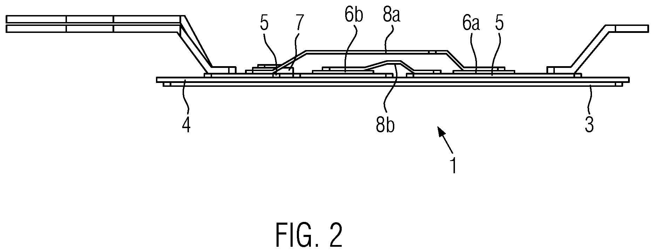

Figure 1 to Figure 4 show an embodiment of a power module which is not subject of claim 1, but which shows the basic structure of such a power module 1.

The power module 1 comprises six power units 2 which are arranged in three groups 16 and connected in parallel.

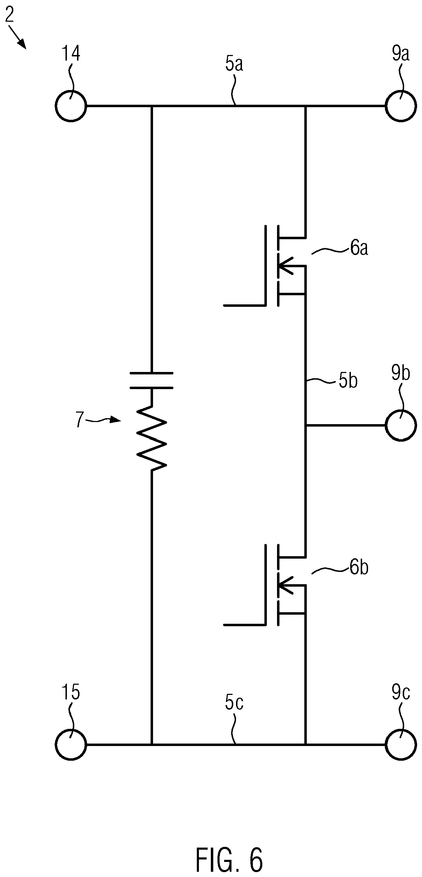

Each power unit 2 consisting of two power transistors (without antiparallel power diodes) forming a leg or a branch of an H-bridge circuit (see Figure 6)

An integrated component 7 shared by a group of two power units 2 to mitigate the electrical noise generated by the power transistors operation.

The power module 1 has a carrier plate 3 on which the components of the individual power units 2 are arranged . The carrier plate 3 is made of a heat conductor, in this case copper alloy, in order to dissipate the temperatures generated by the power module 1.

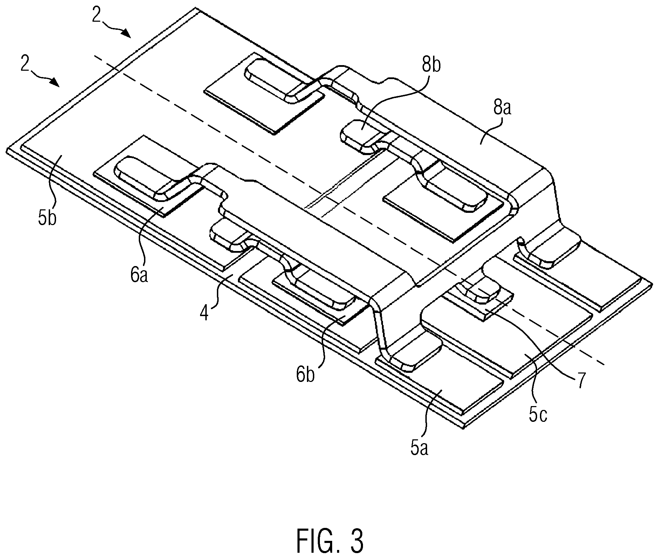

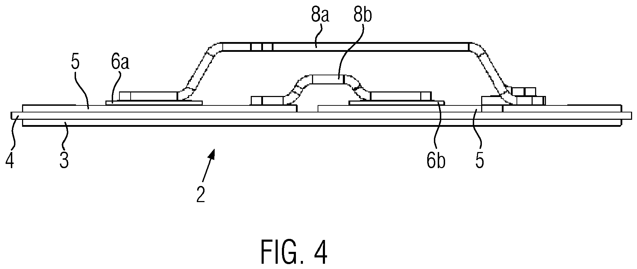

An insulating layer 4 is arranged on the carrier plate 3 to electrically insulate the electrical components from the conductive carrier plate 3. The insulating layer 4 is made of aluminium nitrite (AIN) or aluminium oxide (Al2O3) (figure 3 and 4).

Three electrically conductive substrates 5a, 5b and 5c are arranged on the insulating layer 4 for each power unit 2, whereby two power units 2 of the same group share the substrate 5c in each case.

The substrates 5a, 5b, 5c are formed of copper alloy in order to be able to conduct current effectively.

On each of the two substrates 5b and 5c a power chip 6 is arranged, which are high-power semiconductor transistors. The power chip 6a is arranged on the substrate 5b and the power chip 6b on the substrate 5c.

Conductor tracks 8 connect the individual substrates 5 with the power chips 6.

A first conductor track 8a connects the first substrate 5a to the upper surface of the first power chip 6a.

A second conductor track 8b connects the second substrate 5b on which the first power chip 6a is arranged to the upper surface of the second power chip 6b.

The first power chip 6a and the second power chip 6b are electrically connected with their bottom surfaces to the corresponding substrates 5b and 5c.

The electrical path starts at the first substrate 5a which is electrically connected to the first power chip 6a via the first conductor track 8a. From there, the current travels further to the second substrate 5b. From the second substrate 5b, the current flows via the second conductor track 8b to the second power chip 6b and travels through this to the third substrate 5c.

Thus, the arrangement of the power chips 6 is such that each power unit 2 constitutes one half of an H-bridge (one leg of an H-bridge circuit). To serve this purpose, the power chips 6a and 6b utilized are high-power field-effect transistors, as illustrated in Fig. 6 through their equivalent circuit representation.

It is important to note that in alternative configurations, each of the high-power field-effect transistors may be accompanied by one or more high-power diodes interconnected in an antiparallel configuration. This addition serves to enhance the power rating of the power module. Consequently, in such cases, the power unit 2 must undergo modification to accommodate the additional chips, while retaining the fundamental structure

An integrated component 7 is strategically positioned on the substrate 5c to mitigate the electromagnetic interference resulting from the operation of the power chips 6. The component is shared by two power units 2, and to fulfil this role effectively, a capacitor-resistor chip is the preferred integrated component employed although other integrated components with similar purpose may be employed. This chip is connected to the surface of the power chip 6a through the use of a conductor track 8a.

The conductor tracks 8 are each formed of a plate-shaped electrically conductive body which is made of a metal that is a good conductor of electricity. The metal is, for example, a copper alloy or aluminium alloy.

The first conductor track 8a comprises an arching section 17, which extends over the second power chip 6b (Fig. 4). The two arching sections 17 of the conductor track 8a of a power group 16 are connected to each other via a cross-connection 18 in the neighbouring area above a gap in between the first substrate 5a and third substrate 5c. The cross-connection comprises a contact surface in the middle in between the two arching sections 17 which is connected to the integrated component 7.

The second conductor track 8b comprises also an arching section 19 extending over a gap in between the second substrate 5b and the third substrate 5c (Fig. 4).

The thickness and width of the bridges of the conductor tracks 8 are thickness: 0.4 mm, in the present embodiment, with the design being capable of using 0.2 mm to 1 mm without further change. The width may vary between 1.5 mm and 10 mm, and is 9.5 mm in the present embodiment.

The first and second conductor tracks 8a, 8b have contact surfaces from which the arching sections 17, 19 rise at a predetermined pitch and then run substantially parallel to the conductive plane 5 over a predetermined distance 14 mm and 4 mm respectively.

The arching section 19 of the second conductor track 8b is arranged between the arching section 17 of the first conductor track 8a and the carrier plate 3, so that the two conductor tracks 8 run essentially parallel as a stacked arrangement. The conductor tracks 8 are arranged in close proximity to one another with or without an insulating layer between them, whereby the plate-shaped arching sections 17, 19 are arranged approximately parallel with their wide surfaces facing one another and are connected to the substrates 5a, 5b, 5c and the power chips 6a, 6b in such a way that they conduct current antiparallel. This avoids parasitic inductions.

The distance between the two arching section 17, 19 in the area where they run parallel is defined by the insulation material, but for reasons of practicality larger than 50 micrometres, in the present embodiment 500 micrometres, and not more than 2000 micrometres.

The conductor tracks 8a, 8b are electrically and mechanically connected to the substrates 5a, 5b, 5c and the power chips 6a, 6b by means of sintered interconnection structures.

By using sintered interconnection structures, the individual conductor tracks 8a, 8b can be successively connected to the substrates 5a, 5b, 5c and power chips 6a, 6b, since once a sintered interconnection structure has been created, it will not be dissolved when heated again such as a soldering connection.

The power module 1 further comprises three busbars 9a, 9b, 9c, each of which is electrically connected to one of the substrates 5a, 5b, 5c via internal contact tongues 10.

The bus bars 9a, 9b, 9c serve as connection elements for connecting the power module 1 to power lines (not shown) for carrying current with a high current value. The power module 1 is designed to switch currents of up to 150 A. The current strengths of the currents that are supplied to or drained from the power module via the bus bars 9a, 9b, 9c are accordingly high.

The busbars 9a, 9b, 9c are plate-shaped bodies made of an electrically highly conductive material, in particular metal. The busbars 9a, 9b, 9c consist, for example, of a copper alloy or aluminium alloy. The busbars 9a, 9b, 9c each have a base section 12 which merges into an external contact tongue 11 on one side and has several internal contact tongues 10 on the other side. The internal contact tongues 10 are angled relative to the respective base section 12 of the busbars 9a, 9b, 9c and each have an angled contact foot 13 at their ends remote from the base section 12.

Each busbar 9a, 9b, 9c is connected to the respective substrate 5 via two internal contact tongues 10 for each power unit 2. Because the third substrate 5c is a common component of two power units 2 of the same power group 16, the connection to the busbar 9c comprises four internal contact tongues 10 (Fig. 1).

The contact feet 13 are likewise electrically and mechanically connected to the substrates 5a, 5b, 5c by means of a sintered connection structure, as are the ends of the conductor tracks 8a, 8b, 8c.

Due to the angled shape of the internal contact tongues 10 relative to the base sections 12 of the busbars 9a, 9b, 9c, the busbars 9a, 9b, 9c are arranged with their base sections 12 and the external contact tongues 11 approximately parallel to the plane of the carrier plate 3, but offset a little with respect to the plane of the carrier plate 3. This creates space in the area of the external contact tongues 11 for contacting them with a high-current push-on connector which encloses the external contact tongues 11.

The first and the third busbars 9a and 9c are arranged with their respective base section 8 and with their external contact tongues 11, closely spaced from each other, whereby an insulation layer is provided between the busbars. The first and third busbars 9a and 9c are arranged with their broadside surfaces facing each other. The distance between the bus bars 9a and 9c is typically more than 50 micrometres, in the present embodiment 100 micrometres and not more than 1 mm.

Because the current is supplied via the first bus bar 9a and the current is drained from the power module 1 via the third bus bar 9c, the current flow in these two bus bars 9a, 9c is directed in an antiparallel manner, whereby a parasitic induction is avoided or at least kept low.

The power module 1 has the second busbar 9b on the edge of the carrier board 2 opposite the first and third busbars 9a, 9c.

The second busbar 9b is used to supply a gate potential of the field effect transistors. The currents that are conducted via this busbar 9b are correspondingly low. No antiparallel routing of a current is necessary here, which is why this busbar 9b is arranged individually and freely protruding on the power module 1.

From the third substrate 5c, current flows via the internal contact tongues 10 to the third bus bar 9c and terminates at the third external contact tongue 11c.

A second circuit runs from the first bus bar 9a to the first substrate 5a, then to the first conductor track 8a and to the integrated component 7, from where the current flows to the third substrate 5c. From here, the current flows through the internal contact tongues 10 back to the third bus bar 9c. In the embodiment described herein, the busbar 9a corresponds to the emitter, the busbar 9c to the collector and the busbar 9b to the base of the NPN transistor.

In alternative embodiments, the power unit 2 can also comprise FETs or MOSFETs. In this case, busbar 9a can correspond to the source, busbar 9c to the drain and busbar 9b to the gate of the transistor.

The power module 1 according to the invention has two terminal pins 14, 15, one terminal pin 14 being formed on the first bus bar 9a and the other terminal pin 15 being formed on the third bus bar 9c. The terminal pins 14, 15 are thin pins which are integrally formed on the busbars 9a, 9c and are made of the same electrically conductive material as the busbars 9a, 9c. The terminal pins 14, 15 have a length such that they project outwards from a housing (not shown) of the power module 1.

The terminal pins 14, 15 are naturally arranged in such a way that they are not in contact with the respective other bus bar 9a, 9c. The terminal pins 14, 15 are preferably located adjacent to the edge or side of the base section 8 of the bus bars 9a, 9c on which the internal contact tongues 10 are formed.

The terminal pins 14, 15 enable 4-point measurement, whereby the voltage between the input and output sides of the power module 1 can be sensed via the terminal pins 14, 15 and the current of the input and output sides of the power module 1 can be sensed via the external contact tongues 11. Since the terminal pins 14, 15 pick off the input and output side of the power module 1 very close to the internal contact tongues 10 and thus very close to the power chips 6 and also pick off in an area in which the bus bars 9a, 9c are arranged very close to each other to avoid parasitic induction, on the one hand the circuit noise, which can never be completely avoided when switching such high currents quickly, is low. On the other hand, the influence of parasitic induction is also low, which means that the voltage in the power module 1 can be measured very precisely.

### Reference signs

- 1: Power module
- 2: Power unit
- 3: Carrier plate
- 4: Insulator layer
- 5: Substrate
- 5a: First substrate
- 5b: Second substrate
- 5c: Third substrate
- 6: Power chips
- 6a: first power chip
- 6b: Second power chip
- 7: Integrated component
- 8: Conductor track
- 8a: First conductor track
- 8b: Second conductor track
- 9: Busbar
- 9a: First busbar
- 9b: Second busbar
- 9c: Third busbar
- 10: Internal contact tongues
- 11: External contact tongues
- 12: Base section
- 13: Contact base
- 14: First terminal pin
- 15: Second terminal pin
- 16: Power group
- 17: arching section
- 18: Cross-connection
- 19: Arching section

## Claims

1. Power modulemodul for power applications,
which has two plate-shaped busbars, each having an outer contact tongue for electrically connecting the power module to in each case one power supply line and having a plurality of inner contact tongues for connecting to a conductor track which leads to a contact point of a semiconductor chip or a plurality of semiconductor chips,
the busbars being arranged closely adjacent to one another in order to avoid parasitic induction, and the current flow in the busbars being aligned in an antiparallel manner,
**characterized in**
**that** a terminal pin for a 4-point measurement is provided
at each busbar.

2. Power module according to claim 1,
**characterized in**
**that** the terminal pins are arranged on the same side of the power module and protrude thereon.

3. Power module according to claim 1 or 2,
**characterized in**
**that** the terminal pins are arranged on
the edge region of the busbars adjacent to the side of the busbar on which the internal contact tongues are located.

4. Power module according to one of the claims 1 to 3,
**characterized in that** an insulating layer is provided in between the busbars.

5. Power module according to one of the claims 1 to 4,
**characterized in that** the busbars have at least four internal contact tongues, preferably at least eight internal contact tongues and in particular preferably at least twelve internal contact tongues.

6. Power module according to one of the claims 1 to 5,
**characterized in**
**that** the outer contact tongue and the at least one inner contact tongue are arranged on opposite sides of the bus bar, and/or that the side of the busbar on which the at least one inner contact tongue is arranged is longer than the side of the busbar on which the outer contact tongue is arranged.

7. Power module according to any one of claims 1 to 6,
**characterized in**
**that** the outer contact tongue is wider than the at least one inner contact tongue.

8. Power module according to any one of claims 1 to 7,
**characterized in**
**that** the connections of the conductor tracks are each electrically and mechanically connected by means of a sintered connection structure.

9. Power module according to any one of claims 1 to 8,
**characterized in**
**that** two conductor tracks are arranged closely adjacent to each other with an insulation layer in between to avoid parasitic induction, and the current flow in the conductor tracks is aligned antiparallel.

10. power module according to claim 9,
**characterized in**
**that** one of the two conductor tracks is arranged substantially between the other conductor track and the surface of a carrier board on which the semiconductor chip is located.

11. Power module according to any one of claims 1 to 10
**characterized in**
**that** the conductor tracks have a height and a width perpendicular to the direction of travel, the height pointing substantially away from the carrier board, the width being greater than the height, preferably at least 10 times greater and in particular at least 100 times greater.

12. Power module according to any one of claims 1 to 11,
**characterized in**
**that** the distance between the at least two conductor tracks is not greater than 1 mm, preferably not greater than 0.5 mm and in particular not greater than 0.1 mm.

13. Power module according to any one of claims 1 to 12,
**characterized in**
**that** the power units incorporate a connection to an integrated component to mitigate the electromagnetic interference generated by the power transistor operation.
